# FASCICULE DE BREVET EUROPEEN

(11) **EP 3 772 145 B1**
(45) Date de publication et mention de la délivrance du brevet: **04.05.2022**
(21) Numéro de dépôt: 20188014.3
(22) Date de dépôt: 27.07.2020
(51) Int. Cl.: H01S 5/02, H01S 5/10, H01S 5/12, H01S 5/125

(54) **SOURCE LASER HYBRIDE COMPORTANT UN GUIDE D'ONDE INTEGRE A RESEAU DE BRAGG INTERCALAIRE**
HYBRIDE LASERQUELLE, DIE EINEN INTEGRIERTEN WELLENLEITER MIT EINEM ZWISCHENGESCHALTETEN BRAGG-GITTER UMFASST
HYBRID LASER SOURCE COMPRISING A WAVEGUIDE BUILT INTO AN INTERMEDIATE BRAGG NETWORK

(30) Priorité: 29.07.2019 FR 1908625
(43) Date de publication de la demande: 03.02.2021
(73) Titulaire: Commissariat à l'Energie Atomique et aux Energies Alternatives, 75015 Paris (FR)
(72) Inventeur: HASSAN, Karim, 38054 GRENOBLE Cedex 09 (FR); ADELMINI, Laetitia, 38054 GRENOBLE Cedex 09 (FR); SZELAG, Bertrand, 38054 GRENOBLE Cedex 09 (FR)
(74) Mandataire: INNOV-GROUP

(56) Documents cités:
- EP-A1- 2 988 378
- FR-A1- 3 061 961
- FERROTTI THOMAS ET AL: "O-Band III-V-on-Amorphous-Silicon Lasers Integrated With a Surface Grating Coupler", IEEE PHOTONICS TECHNOLOGY LETTERS, IEEE SERVICE CENTER, PISCATAWAY, NJ, US, vol. 28, no. 18, 15 septembre 2016 (2016-09-15), pages 1944-1947, XP011615745, ISSN: 1041-1135, DOI: 10.1109/LPT.2016.2578182 [extrait le 2016-07-01]
- DUPREZ H ET AL: "Heterogeneously integrated III-V on silicon distributed feedback lasers at 131", 2015 OPTICAL FIBER COMMUNICATIONS CONFERENCE AND EXHIBITION (OFC), OSA, 22 mars 2015 (2015-03-22), pages 1-3, XP032784489,
- PO DONG ET AL: "Novel integration technique for silicon/III-V hybrid laser", OPTICS EXPRESS, vol. 22, no. 22, 21 octobre 2014 (2014-10-21), page 26854, XP055424657, DOI: 10.1364/OE.22.026854
- SZELAG BERTRAND ET AL: "Hybrid III-V/Silicon Technology for Laser Integration on a 200-mm Fully CMOS-Compatible Silicon Photonics Platform", IEEE JOURNAL OF SELECTED TOPICS IN QUANTUM ELECTRONICS, IEEE SERVICE CENTER, PISCATAWAY, NJ, US, vol. 25, no. 5, 1 septembre 2019 (2019-09-01), pages 1-10, XP011736125, ISSN: 1077-260X, DOI: 10.1109/JSTQE.2019.2904445 [extrait le 2019-07-24]

## Description

### DOMAINE TECHNIQUE

Le domaine de l'invention est celui des sources laser à semiconducteur, et plus précisément des sources laser dites hybrides, c'est-à-dire que la cavité optique est définie par au moins un réseau de Bragg situé dans un substrat fonctionnalisé par exemple de type SOI, sur lequel a été reporté un plot semiconducteur par exemple de type III-V contenant le milieu à gain.

### ÉTAT DE LA TECHNIQUE ANTÉRIEURE

D'une manière générale, une puce photonique comporte au moins un composant optoélectronique, par exemple une source laser, qui repose sur un substrat dit fonctionnalisé dans la mesure où il comporte un circuit photonique intégré. Un tel circuit photonique intégré comporte un guide d'onde, couplé à la source laser, ainsi que des composants optiques actifs (modulateurs...) et/ou passifs (multiplexeurs...). Dans le cas des technologies de la photonique sur silicium, la source laser est réalisée à base d'un composé semiconducteur, par exemple un composé III-V tel que de l'InP, et le substrat fonctionnalisé peut être de type SOI (*Silicon On Insulator*, en anglais) intégrant des guides d'onde en silicium.

La source laser est dite hybride dans la mesure où la cavité optique de la source laser est définie par des réflecteurs situés dans le substrat fonctionnalisé. Plus précisément, la source laser est formée d'un plot semiconducteur en un composé III-V qui comporte le matériau à gain. Le matériau à gain est situé dans un guide d'onde dit actif. Dans le cas d'un laser DBR (*Distributed Bragg Reflector,* en anglais), la cavité optique est délimitée par deux réseaux de Bragg situés dans le guide d'onde intégré, qui forment des miroirs sélectifs en longueur d'onde. Dans le cas d'un laser DFB (*Distributed FeedBack,* en anglais), un même réseau de Bragg s'étend dans le guide d'onde intégré sur toute la longueur de la cavité optique.

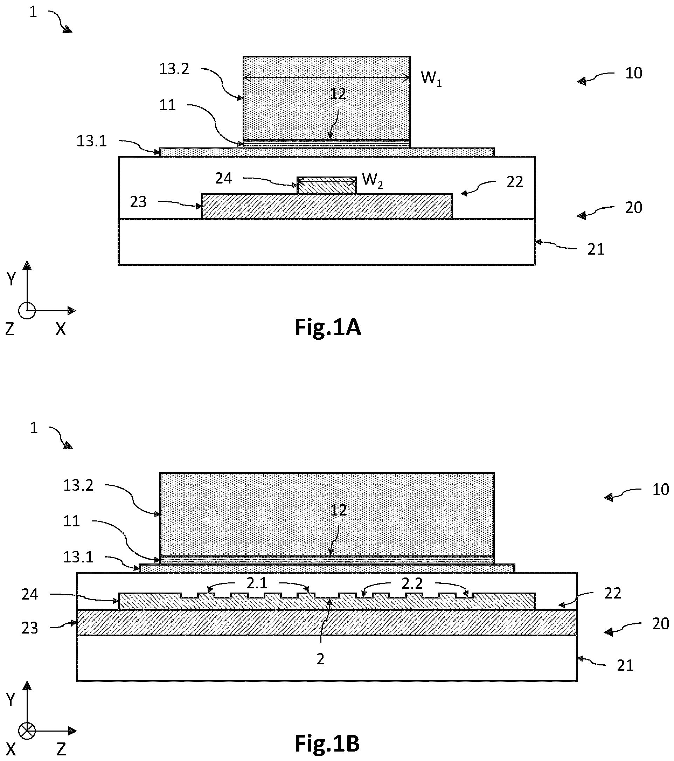

Les figures 1A et 1B sont des vues en coupe d'un exemple de source laser hybride III-V/Si de type DFB décrite dans l'article de Szelag et al. intitulé Hybrid III-V/Si DFB laser intégration on a 200mm fully CMOS-compatible silicon photonics platform, 2017 IEEE International Electron Devices Meeting (IEDM), Jan. 2018. La source laser 1 est formée d'un plot semiconducteur 10 réalisé à base d'InP contenant une couche de puits quantiques 11 située entre deux couches semiconductrices dopées 13.1, 13.2 et disposée dans le guide d'onde actif 12. Par ailleurs, le substrat fonctionnalisé 20 comporte le guide d'onde intégré 22 réalisé en silicium, lequel correspond ici à un guide en arête formé d'une première partie 23, ici un plateau (*slab*, en anglais), sur laquelle repose une deuxième partie 24, ici une arête longitudinale (*rib*, en anglais). Dans cet exemple, le plateau 23 présente une épaisseur constante de 300nm environ dans le substrat fonctionnalisé 20, c'est-à-dire dans et en-dehors de la zone de couplage avec le plot semiconducteur 10. Et l'arête longitudinale 24 est présente uniquement dans la zone de couplage avec le plot semiconducteur 10, et présente une épaisseur de 200nm environ. Aussi, le guide d'onde intégré 22 présente, dans la zone de couplage, une épaisseur de 500nm environ, de manière à optimiser le couplage optique entre les deux guides d'onde 12, 22. Le réseau de Bragg 2 est habituellement situé sur la face supérieure de l'arête longitudinale 24.

Notons que l'article de Ferrotti et al. intitulé O-Band III-V-on-Amorphous-Silicon Lasers Integrated With a Surface Grating Coupler, IEEE Photonics Technology Letters, Vol.28, No.18, p.1944-1947, 2016, décrit une source laser hybride de type DFB similaire à celle décrit précédemment, dont le guide d'onde intégré comporte un réseau de Bragg situé au niveau de de la face supérieure de l'arête longitudinale.

Selon une approche, le procédé de fabrication d'une telle source laser peut comporter la fourniture d'un substrat SOI dont la couche de silicium monocristallin présente une épaisseur constante de 500nm. Le procédé comporte alors une étape de gravure localisée du silicium monocristallin de manière à garder une épaisseur de 500nm environ dans la zone de couplage avec le plot semiconducteur III-V, et de réduire cette épaisseur à 300nm environ en-dehors de la zone de couplage. Cependant, il est délicat de contrôler précisément l'épaisseur du guide d'onde intégré dans la zone gravée. D'autre part, l'état de surface du guide d'onde intégré dans la zone gravée peut induire des pertes optiques.

Selon une autre approche (décrite dans l'article Szelag et al. 2018), le procédé de fabrication comporte la réalisation du plateau à partir d'une couche de silicium monocristallin d'une épaisseur de 300nm environ d'un substrat SOI, puis la réalisation d'une arête longitudinale d'une épaisseur de 200nm environ par un procédé damascène (dépôt de silicium puis planarisation mécano-chimique). Ainsi, le guide d'onde intégré est formé principalement du plateau en silicium monocristallin de 300nm d'épaisseur issu du substrat SOI et de l'arête longitudinale en silicium amorphe de 200nm d'épaisseur. Aussi, le guide d'onde intégré présente l'épaisseur locale requise de 500nm environ sous le guide d'onde actif, ce qui améliore le couplage optique entre les deux guides d'onde, mais garde une épaisseur de 300nm environ en dehors de la zone de couplage avec le plot semiconducteur III-V, cette épaisseur de 300nm étant propice aux diverses fonctions optiques mises en œuvre par le circuit photonique intégré. On limite ainsi la dégradation des propriétés optiques du guide d'onde intégré par l'étape de gravure localisée mentionnée plus haut.

Cependant, il existe un besoin de disposer d'une source laser hybride dont le guide d'onde intégré comporte deux parties longitudinales disposées l'une sur l'autre et au moins un réseau de Bragg, dont les performances souhaitées sont préservées lors de la mise en œuvre du procédé de fabrication.

### EXPOSÉ DE L'INVENTION

L'invention a pour objectif de remédier au moins en partie aux inconvénients de l'art antérieur, et plus particulièrement de proposer une source laser hybride dont les performances souhaitées sont préservées au cours du procédé de fabrication mis en œuvre, voire améliorées.

Pour cela, l'objet de l'invention est une source laser comportant un substrat dit fonctionnalisé, comportant un guide d'onde dit intégré. Celui-ci est formé d'un empilement d'une première partie et d'une deuxième partie, une face supérieure de la première partie étant revêtue au moins partiellement par une deuxième partie, et comporte au moins un réseau de Bragg. La source laser comporte en outre un plot semiconducteur, reposant sur le substrat fonctionnalisé, comportant un matériau à gain situé dans un guide d'onde dit actif, le guide d'onde actif étant situé à la perpendiculaire du guide d'onde intégré et orienté parallèlement à celui-ci, les deux guides d'onde étant couplés optiquement l'un à l'autre. Selon l'invention, le réseau de Bragg est situé dans la face supérieure de la première partie, et est recouvert par la deuxième partie.

Certains aspects préférés mais non limitatifs de cette source laser sont les suivants.

Le réseau de Bragg est formé avantageusement par une alternance périodique de dents et de creux, les creux étant remplis par un matériau de bas indice de réfraction inférieur à l'indice de réfraction des première et deuxième parties.

La deuxième partie repose avantageusement sur une surface sensiblement plane.

Le guide d'onde intégré peut être réalisé en silicium et est entouré d'un oxyde de silicium. Le réseau de Bragg peut comporter des creux remplis par un oxyde ou par un nitrure de silicium.

La première partie du guide d'onde intégré peut être réalisée en silicium cristallin, et la deuxième partie peut être réalisée en silicium amorphe.

Le réseau de Bragg peut comporter une alternance périodique de dents et de creux, la deuxième partie étant au contact des dents du réseau de Bragg.

Le réseau de Bragg peut comporter une alternance périodique de dents et de creux, le guide d'onde intégré comportant une couche mince continue en un matériau de bas indice de réfraction qui recouvre la première partie et remplit les creux du réseau de Bragg, la deuxième partie étant espacée de la première partie par la couche mince continue.

La deuxième partie peut former une arête longitudinale d'une largeur inférieure à celle de la première partie.

L'invention porte également sur un procédé de fabrication d'une source laser selon l'une quelconque des caractéristiques précédentes. Le procédé comporte les étapes suivantes :
∘ réalisation d'une première partie du guide d'onde intégré reposant sur une couche de base ;
∘ réalisation d'au moins un réseau de Bragg dans la face supérieure de la première partie opposée à la couche de base, le réseau de Bragg étant formé d'une alternance de dents et de creux ;
∘ remplissage des creux par un matériau de bas indice de réfraction ;
∘ réalisation d'une deuxième partie du guide d'onde intégré sur la première partie et recouvrant le réseau de Bragg ;
∘ réalisation d'une couche supérieure recouvrant la deuxième partie ;
∘ réalisation du plot semiconducteur reposant sur la couche supérieure.

L'étape de réalisation de la première partie peut être effectuée par gravure localisée d'une couche de silicium cristallin d'un substrat SOI, la première partie présentant une épaisseur égale à l'épaisseur de la couche de silicium cristallin et homogène spatialement.

L'étape de réalisation de la deuxième partie du guide d'onde intégré peut être effectuée par un procédé damascène comportant les étapes suivantes :
∘ réalisation d'une couche formant un masque et recouvrant la première partie et le réseau de Bragg ;
∘ réalisation d'une ouverture longitudinale à la perpendiculaire du réseau de Bragg ;
∘ dépôt de silicium amorphe remplissant l'ouverture longitudinale ;
∘ planarisation mécano-chimique de manière à rendre libre une face supérieure du masque et à conserver le silicium amorphe remplissant l'ouverture longitudinale.

Le réseau de Bragg peut être formé d'une alternance périodique de dents et de creux. A la suite de l'étape de réalisation de l'ouverture longitudinale, une surface de la face supérieure de la première partie peut être rendue libre, ladite surface libre étant formée par des dents en silicium et par le matériau de bas indice de réfraction remplissant les creux du réseau de Bragg.

Le réseau de Bragg peut être formé d'une alternance périodique de dents et de creux. A la suite de l'étape de réalisation de l'ouverture longitudinale, une couche mince continue de la couche en oxyde de silicium peut recouvrir les dents en silicium et peut remplir les creux du réseau de Bragg.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B, déjà décrites, sont des vues schématiques et partielles, en coupe transversale (fig. 1A) et en coupe longitudinale (fig. 1B) d'une source laser hybride selon un exemple de l'art antérieur ;
les figures 2A à 2H illustrent certaines étapes d'un procédé de fabrication d'une source laser identique ou similaire à celle illustrée sur les fig.1A et 1B, mettant en évidence une dégradation des performances du réseau de Bragg ;
les figures 3A à 3J illustrent certaines étapes d'un procédé de fabrication d'une source laser selon un mode de réalisation ;
les figures 4A à 4C sont des exemples de réponses spectrales en réflectivité pour différents guides d'ondes intégrés comportant un réseau de Bragg ;
les figures 5A à 5D illustrent différentes étapes d'un procédé de fabrication d'une source laser selon une variante de réalisation ;
les figures 6A à 6D illustrent différentes étapes d'un procédé de fabrication d'une source laser selon une autre variante de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

Les figures 1A et 1B, déjà décrites brièvement plus haut, sont des vues schématiques et partielles, en coupe transversale (fig.1A) et longitudinale (fig.1B), d'une source laser 1 selon un exemple de l'art antérieur.

On définit ici et pour la suite de la description un repère direct tridimensionnel orthogonal XYZ, où le plan XZ est un plan parallèle au plan du substrat fonctionnalisé 20, l'axe Z étant orienté suivant l'axe longitudinal du guide d'onde actif, l'axe X étant orienté suivant la largeur des guides d'onde, et où l'axe Y est orienté du substrat fonctionnalisé 20 vers le plot semiconducteur 10 de la source laser 1. Dans la suite de la description, les termes « inférieur » et « supérieur » s'entendent comme étant relatifs à un positionnement croissant suivant la direction +Y.

La source laser 1 est ici de type DFB (*Distributed Feedback*, en anglais), mais elle peut tout autant être de type DBR. Elle comporte un plot semiconducteur 10 réalisé en au moins un composé semiconducteur, ici de type III-V, et disposé sur un substrat fonctionnalisé 20, ici de type SOI (plaque de silicium sur isolant). La cavité optique est formée par un réseau de Bragg 2 situé dans le guide d'onde intégré 22, qui s'étend longitudinalement en regard du guide d'onde actif 12.

Le plot semiconducteur 10 contient le milieu à gain, lequel est situé dans un premier guide d'onde dit actif. Il comporte une couche 11 contenant une alternance de multiples puits quantiques et de couches barrières, les puits quantiques étant par exemple réalisés en InGaAsP (ou AlGaInAs), avec un maximum de gain par exemple centré sur la longueur d'onde λ égale à 1310nm. La couche de puits quantiques 11 est encadrée suivant l'axe Y par des couches semiconducteurs dopées n et p, par exemple réalisées en InP. Aussi, le plot semiconducteur 10 comporte une jonction PIN qui s'étend de manière parallèle au plan XZ. Le guide d'onde actif 12 comporte des moyens d'amplification optique pour produire une émission stimulée de lumière, ici la couche de puits quantiques 11. Il s'étend suivant une direction longitudinale, ici suivant l'axe Z.

Le substrat fonctionnalisé 20 est un substrat assurant le support du plot semiconducteur 10 et intégrant des fonctions optiques d'un circuit photonique. Il comporte pour cela un deuxième guide d'onde, dit intégré, appartenant au circuit photonique intégré. Le substrat fonctionnalisé 20 est ici de type SOI (*Silicon On Insulator*, en anglais), de sorte que le guide d'onde intégré 22 comporte un cœur réalisé en silicium entouré d'un oxyde de silicium formant la gaine. Plus précisément, le substrat fonctionnalisé 20 comporte : une couche de base 21 en oxyde de silicium ; le guide d'onde intégré 22 en silicium qui repose sur la couche de base 21 ; et au moins une couche d'oxyde de silicium qui entoure le guide d'onde intégré 22 et assure un espacement vertical suivant l'axe Y entre ce dernier et le plot semiconducteur 10.

Le guide d'onde intégré 22 comporte une première partie 23 qui repose au contact de la couche de base 21, et une deuxième partie 24 qui repose sur la première partie 23. La première partie 23 est ici réalisée en silicium cristallin, de préférence monocristallin, et provient de la couche de silicium cristallin du substrat SOI. La deuxième partie 24 peut être réalisée en silicium amorphe. Il s'agit donc d'un empilement, suivant l'axe Y, de la première partie longitudinale 23 et de la deuxième partie longitudinale 24, lesquelles s'étendent longitudinalement suivant l'axe du guide d'onde intégré 22. Dans cet exemple, le guide d'onde intégré 22 est un guide en arête. Autrement dit, la première partie 23 forme un plateau 23 (*slab*), et la deuxième partie 24 forme une arête longitudinale (*rib,* en anglais). L'arête longitudinale 24 est une nervure étroite en saillie vis-à-vis du plateau 23 suivant la direction +Y. La largeur W₂ du guide d'onde intégré 22 est ici la largeur de l'arête longitudinale 24 suivant l'axe X, qui est inférieure à la largeur du plateau 23. Le guide d'onde intégré 22 est espacé du plot semiconducteur 10 par une couche supérieure 26 d'oxyde de silicium. Le guide d'onde intégré 22 est orienté, dans la zone de couplage optique, parallèlement au guide d'onde actif 12, et est situé à la perpendiculaire de celui-ci suivant l'axe Y. Les deux guides d'onde sont couplés optiquement l'un à l'autre de manière à supporter un mode optique hybride.

Le guide d'onde intégré 22 comporte ici un réseau de Bragg 2 définissant la cavité optique. Le réseau de Bragg 2 est ici distribué le long d'au moins une partie du guide d'onde actif 12 (source laser de type DFB). Il est formé par une alternance périodique de dents 2.1 et de creux 2.2 formés dans la face supérieure de l'arête longitudinale 24 du guide d'onde intégré 22. Les creux 2.2 sont ainsi remplis par la couche supérieure 26 d'oxyde de silicium. Aussi, le réseau de Bragg 2 est situé sur la face du guide d'onde intégré 22 orientée vers le plot semiconducteur 10.

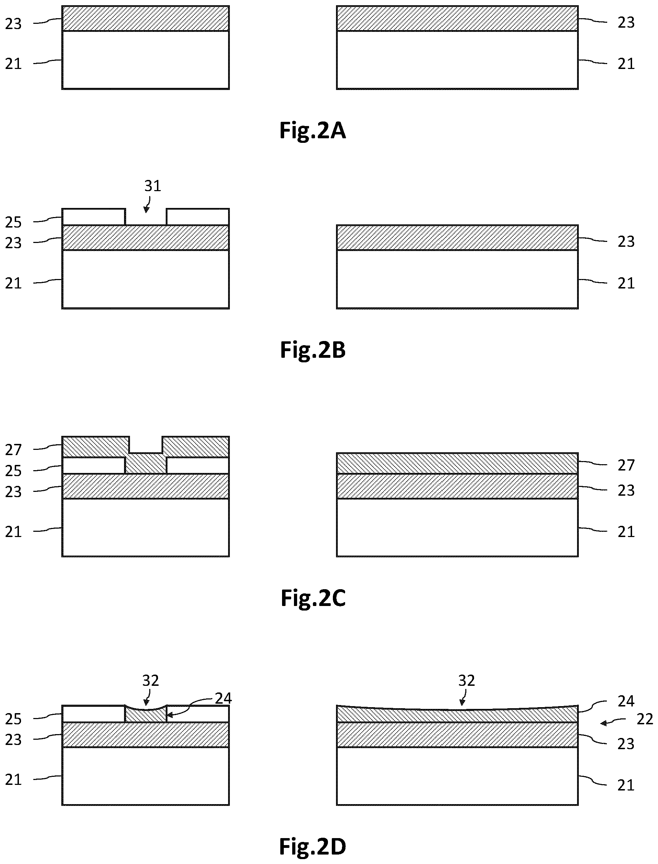

Les figures 2A à 2H illustrent un exemple de procédé de fabrication d'une source laser hybride 1 similaire à celle décrite précédemment en référence aux fig.1A et 1B. Chaque figure comporte une vue (à gauche) en coupe transversale dans un plan XY, et une vue (à droite) en coupe longitudinale dans un plan YZ passant par le centre du guide d'onde intégré 22.

La figure 2A illustre une première étape de réalisation de la première partie 23 du guide d'onde intégré 22, ici du plateau 23. Le plateau 23 est réalisé par structuration d'une couche de silicium monocristallin d'un substrat SOI. Il présente une épaisseur H1 égale à celle de la couche de silicium monocristallin, par exemple à 300nm environ, et repose sur une couche épaisse d'oxyde de silicium, par exemple du SiO₂, d'une épaisseur de l'ordre de quelques dizaines à centaines de microns. Le plateau 23 peut présenter une largeur W1 par exemple égale à 10µm et est entouré latéralement, dans le plan XZ, par une couche d'oxyde de silicium (non représentée).

La figure 2B illustre la réalisation d'une ouverture longitudinale 31 dans une couche intermédiaire 25, en vue de la formation de l'arête longitudinale 24. Pour cela, on dépose une couche intermédiaire 25, par exemple en oxyde de silicium, de manière à recouvrir le plateau 23, puis on réalise par photolithographie une ouverture longitudinale 31 débouchant sur une surface du silicium monocristallin. L'ouverture s'étend longitudinalement suivant l'axe Y. L'ouverture longitudinale 31 présente une profondeur correspondant à la hauteur H2 souhaitée de l'arête longitudinale 24, par exemple ici 200nm environ. La largeur de l'ouverture longitudinale 31 suivant l'axe X définit la largeur W2 de l'arête longitudinale 24, et peut être égale à 3µm environ.

La figure 2C illustre le dépôt de silicium amorphe. Pour cela, on réalise un dépôt pleine plaque d'une couche 27 de silicium amorphe de manière à remplir entièrement l'ouverture longitudinale 31 formée dans la couche intermédiaire 25.

La figure 2D illustre la planarisation par polissage mécano-chimique (CMP) du silicium amorphe déposé, de manière à conserver le silicium amorphe situé dans l'ouverture longitudinale 31, et à supprimer le silicium amorphe reposant sur la face supérieure de la couche intermédiaire 25. On obtient ainsi une arête longitudinale 24 en silicium amorphe d'une largeur W2 de 3µm environ et d'une épaisseur H2 de l'ordre de 200nm environ, reposant au contact du plateau 23 en silicium monocristallin d'une largeur W1 de 10µm environ et d'une épaisseur de 300nm environ.

Cependant, les inventeurs ont constaté que cette étape de planarisation par CMP peut conduire à la formation d'une dépression 32 (*dishing*, en anglais) dans la portion de silicium amorphe située dans l'ouverture longitudinale 31. Autrement dit, une concavité est formée dans la portion de silicium amorphe à partir de sa face supérieure, se traduisant par une variation de l'épaisseur H2 dans le plan XZ. Aussi, l'épaisseur H2 présente une valeur sensiblement égale à 200nm environ en bordure de l'arête longitudinale 24, et diminue en direction du centre de l'arête longitudinale 24. La dépression 32 peut présenter une valeur maximale de l'ordre de quelques dizaines de nanomètres, par exemple 25nm environ, ce qui est du même ordre de grandeur que la profondeur des creux 2.2 du réseau de Bragg 2 (entre 10nm environ pour une source DBR et 50nm environ pour une source DFB).

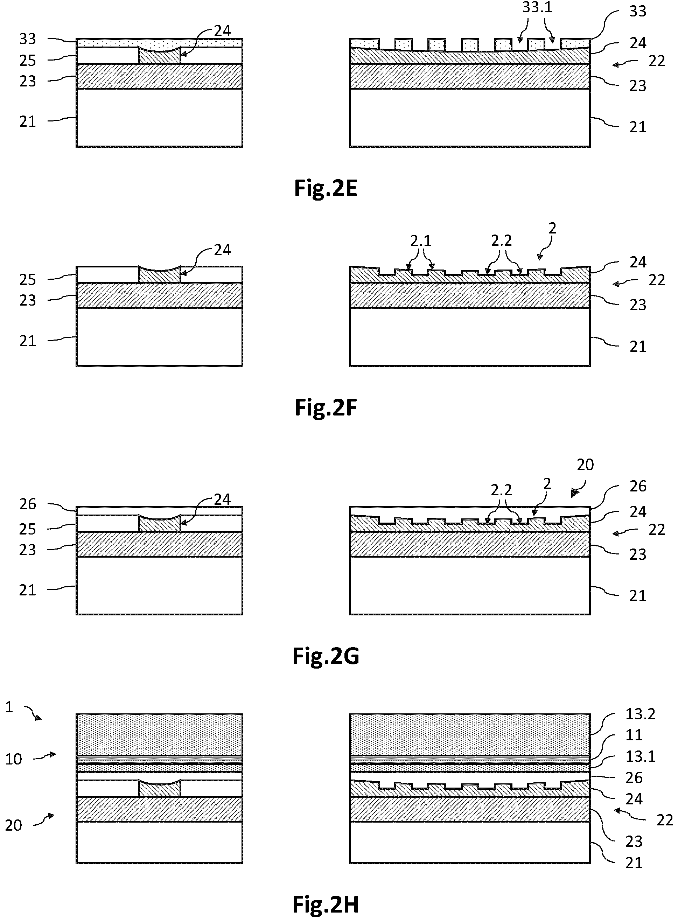

Les figures 2E et 2F illustre la réalisation du réseau de Bragg 2 dans l'arête longitudinale 24 du guide d'onde intégré 22 à partir de la face supérieure de l'arête longitudinale 24. Pour cela, on dépose un masque de gravure 33 de manière à recouvrir l'arête longitudinale 24 et on réalise des échancrures 33.1, ici traversantes, destinées à la réalisation du réseau de Bragg 2. Le matériau du masque de gravure 33 peut être, entre autres, un nitrure de silicium. Une gravure sèche de type RIE est ensuite effectuée de manière à former le réseau de Bragg 2 dans l'arête longitudinale 24 à partir de sa face supérieure, et le masque de gravure 33 est entièrement supprimé. Le réseau de Bragg 2 est alors formé d'une alternance périodique de creux 2.2 et de dents 2.1.

Dans cet exemple, la profondeur des creux 2.2 est de l'ordre de 50nm environ, mais il apparaît que, du fait de la dépression 32 causée par la planarisation CMP, elle n'est pas homogène dans le plan XZ. Il en résulte une inhomogénéité spatiale non souhaitée des dimensions des motifs du réseau de Bragg 2 qui peut conduire à une dégradation des performances du réseau de Bragg 2 et donc de la source laser 1.

La figure 2G illustre le dépôt de la couche supérieure 26 d'oxyde de silicium, de manière à recouvrir entièrement la couche intermédiaire 25 d'oxyde de silicium et l'arête longitudinale 24 de silicium amorphe. Cette couche supérieure 26 assure l'espacement entre le guide d'onde intégré 22 et le plot semiconducteur 10, et peut présenter une épaisseur par exemple égale à 100nm environ (de préférence comprise entre 80nm et 140nm environ).

La figure 2H illustre la réalisation du plot semiconducteur 10 sur le substrat fonctionnalisé 20. De manière connue, on réalise un assemblage par collage sur le substrat fonctionnalisé 20 d'un empilement de couches semiconductrices ici de type III-V comportant des puits quantiques. Des étapes de structuration de l'empilement semiconducteur sont ensuite effectuées pour obtenir le plot semiconducteur 10 de dimension souhaitée. Les étapes connues d'encapsulation du plot semiconducteur 10 par une couche de passivation et de réalisation des électrodes de polarisation ne sont pas décrites.

Il en résulte que ce procédé de fabrication d'une source laser 1 identique ou similaire à celle illustrée sur les fig.1A et 1B, qui met en œuvre un procédé damascène (remplissage de l'ouverture longitudinale 31 puis planarisation mécano-chimique), peut conduire à une dépression 32 (*dishing*) dans le silicium amorphe déposé destiné à former l'arête longitudinale 24. Cette dépression 32, qui se traduit par une inhomogénéité spatiale de l'épaisseur du silicium amorphe, conduit à ce que les dimensions du réseau de Bragg 2 soient inhomogènes dans le plan XZ. Les performances du réseau de Bragg 2 et donc de la source laser 1 peuvent donc être dégradées.

Par ailleurs, en référence à la fig.2F, les inventeurs ont constaté que, à la suite de la réalisation des motifs du réseau de Bragg 2, le contact physique transversal, c'est-à-dire suivant l'axe X, peut être localement rompu entre le silicium amorphe des dents 2.1 et l'oxyde de silicium de la couche intermédiaire 25. Ce défaut de contact physique entre les matériaux se traduit par la présence de zones vides située d'un côté ou de l'autre des dents 2.1 suivant l'axe X, à l'interface entre les dents 2.1 en silicium amorphe et la couche intermédiaire 25 en oxyde de silicium. Ces zones vides peuvent entraîner des pertes optiques dégradant les performances du guide d'onde intégré 22, et donc également celles de la source laser (notamment altération de la longueur d'onde d'émission).

Aussi, pour préserver les performances du réseau de Bragg 2 lors du procédé de fabrication, et ainsi obtenir un réseau de Bragg 2 dont les dimensions des dents 2.1 et des creux 2.2 restent homogènes dans le plan XZ, le réseau de Bragg 2 de la source laser 1 selon l'invention est situé entre la première partie 23 et la deuxième partie 24 du guide d'onde intégré 22 et est formé à partir de la face supérieure de la première partie 23. On obtient ainsi un réseau de Bragg 2 dit intercalaire. De plus, cette disposition du réseau de Bragg 2 au sein du guide d'onde intégré 22 permet d'éviter la formation de zones vides situées à l'interface entre les dents 2.1 et la couche intermédiaire 25.

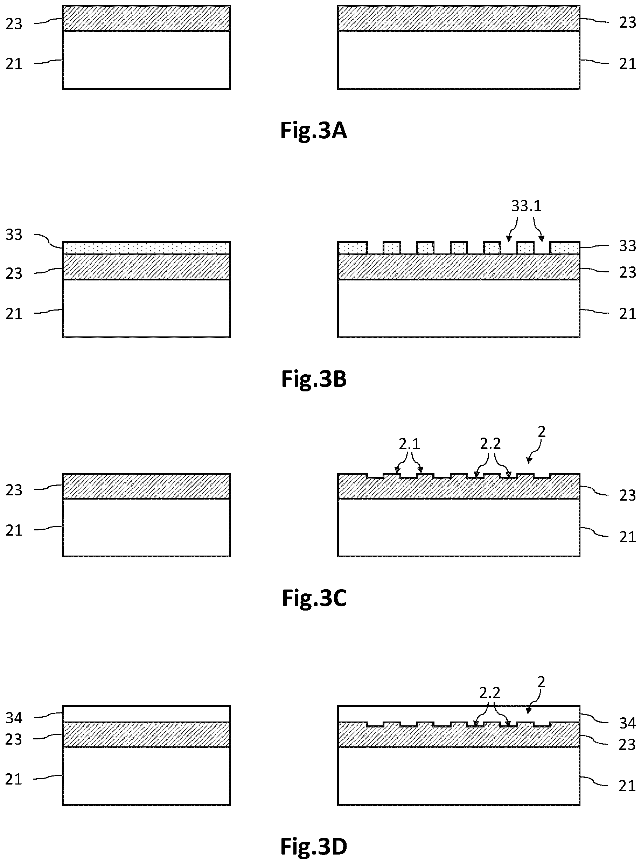

Les figures 3A à 3J illustrent un procédé de fabrication d'une source laser hybride 1 selon un mode de réalisation. Dans cet exemple, la source laser 1 est de type DFB mais elle pourrait tout autant être de type DBR. Chaque figure comporte une vue (à gauche) en coupe transversale dans un plan XY, et une vue (à droite) en coupe longitudinale dans un plan YZ passant par le centre du guide d'onde intégré 22. La source laser 1 selon ce mode de réalisation diffère de celle décrite en référence aux fig.1A et 1B essentiellement en ce que le réseau de Bragg 2 est disposé dans la première partie 23 au niveau de sa face supérieure, et non pas dans la deuxième partie 24. Dans cet exemple, le guide d'onde intégré 22 étant un guide en arête, la première partie 23 est un plateau 23 et la deuxième partie 24 est l'arête longitudinale 24.

La figure 3A illustre une première étape de réalisation du plateau 23 du guide d'onde intégré 22. Le plateau 23 est formé par structuration d'une couche de silicium cristallin d'un substrat SOI, de sorte qu'il présente une épaisseur H1 égale à celle de la couche de silicium d'un substrat SOI, par exemple 300nm environ. Il repose sur une couche épaisse d'oxyde de silicium, par exemple du SiO₂, d'une épaisseur par exemple comprise entre 720nm et quelques microns. Cette étape est similaire ou identique à celle décrite précédemment en référence à la fig.2A.

Les figures 3B et 3C illustrent la réalisation du réseau de Bragg 2 dans le plateau 23 en silicium cristallin à partir de sa face supérieure. Pour cela, on dépose un masque de gravure 33 (par ex. du Si₃N₄) de manière à recouvrir le plateau 23, et on réalise des échancrures 33.1, ici traversantes, destinées à la réalisation du réseau de Bragg 2. Une gravure sèche de type RIE est ensuite effectuée de manière à former le réseau de Bragg 2 dans le plateau 23 en silicium cristallin à partir de sa face supérieure, et le masque de gravure 33 est entièrement supprimé.

Dans la mesure où le plateau 23 en silicium cristallin est issu de la couche de silicium du substrat SOI et n'est pas formé par un procédé damascène, elle présente une épaisseur H1 sensiblement homogène dans le plan XZ. Aussi, les dimensions des motifs du réseau de Bragg 2 sont homogènes dans le plan XZ.

La figure 3D illustre le dépôt d'une couche de remplissage 34 en un matériau de bas indice, par exemple un oxyde de silicium ou un nitrure de silicium. Ici, un oxyde de silicium est déposé, et recouvre le plateau 23 et donc remplit donc entièrement les creux 2.2 du réseau de Bragg 2. La couche de remplissage 34 est avantageusement en oxyde de silicium, et peut ainsi participer à la réalisation de l'arête longitudinale 24 tout en formant ensuite la couche intermédiaire 25 entourant ultérieurement l'arête longitudinale 24 dans le plan XZ.

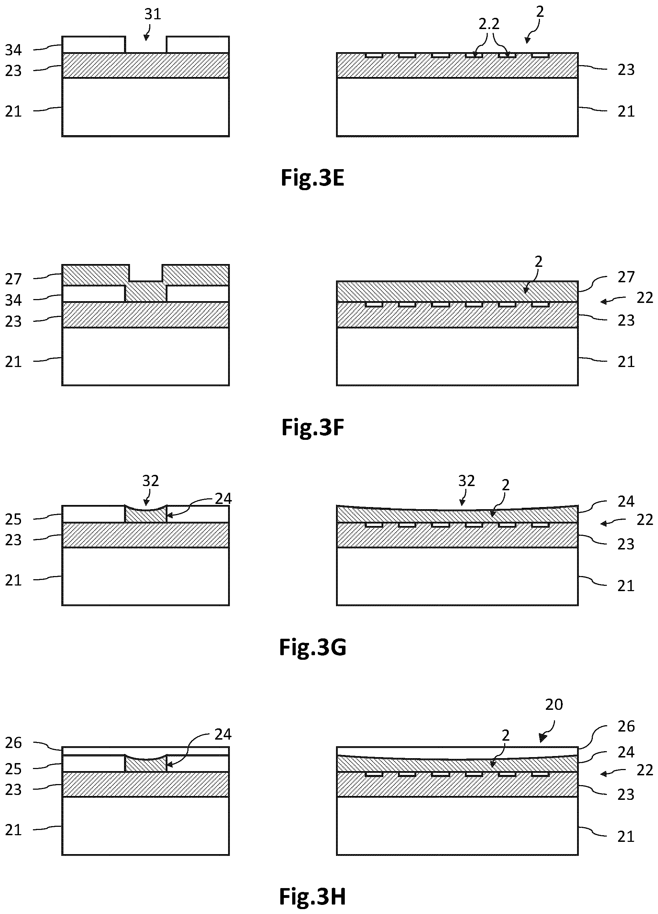

La figure 3E illustre la réalisation d'une ouverture longitudinale 31 dans la couche de remplissage 34, destinée à la réalisation de l'arête longitudinale 24 en silicium amorphe du guide d'onde intégré 22. L'ouverture longitudinale 31 est ici réalisée par gravure sèche avec détection de la fin de gravure sur le silicium cristallin du plateau 23. L'ouverture longitudinale 31 est donc ici traversante, de sorte que la face supérieure des dents 2.1 en silicium cristallin est rendue libre alors que les creux 2.2 du réseau de Bragg 2 restent remplis par le matériau de bas indice, ici l'oxyde de silicium.

La figure 3F illustre le dépôt de silicium amorphe. Pour cela, on réalise un dépôt pleine plaque d'un couche 27 de silicium amorphe de manière à remplir entièrement l'ouverture longitudinale 31 formée dans la couche intermédiaire 25 d'oxyde de silicium. Le silicium amorphe vient donc au contact du silicium cristallin des dents 2.1 du réseau de Bragg 2 et de l'oxyde de silicium remplissant les creux 2.2.

La figure 3G illustre la planarisation par polissage mécano-chimique (CMP) du silicium amorphe déposé, de manière à conserver le silicium amorphe situé dans l'ouverture longitudinale 31 de la couche d'oxyde de silicium et à supprimer le silicium amorphe reposant sur la face supérieure de la couche de remplissage 34. Dans cet exemple, la couche de remplissage 34 étant un oxyde de silicium, elle est avantageusement conservée et forme la couche intermédiaire 25 qui participe à entourer le guide d'onde intégré 22 dans le plan XZ. Cette étape de planarisation par CMP peut conduire à la formation d'une dépression 32 dans l'arête longitudinale 24 de silicium amorphe. Celle-ci présente donc une inhomogénéité d'épaisseur dans le plan XZ. Cependant, à la différence du procédé décrit précédemment, cette inhomogénéité d'épaisseur du silicium amorphe planarisé par CMP ne présente aucun impact sur les dimensions et donc sur les performances du réseau de Bragg 2.

La figure 3H illustre le dépôt de la couche supérieure 26 d'oxyde de silicium, de manière à recouvrir entièrement la couche intermédiaire 25 d'oxyde de silicium et l'arête longitudinale 24 de silicium amorphe. Cette couche supérieure 26 assure l'espacement entre le guide d'onde intégré 22 et le plot semiconducteur 10, et peut présenter une épaisseur par exemple égale à 100nm environ.

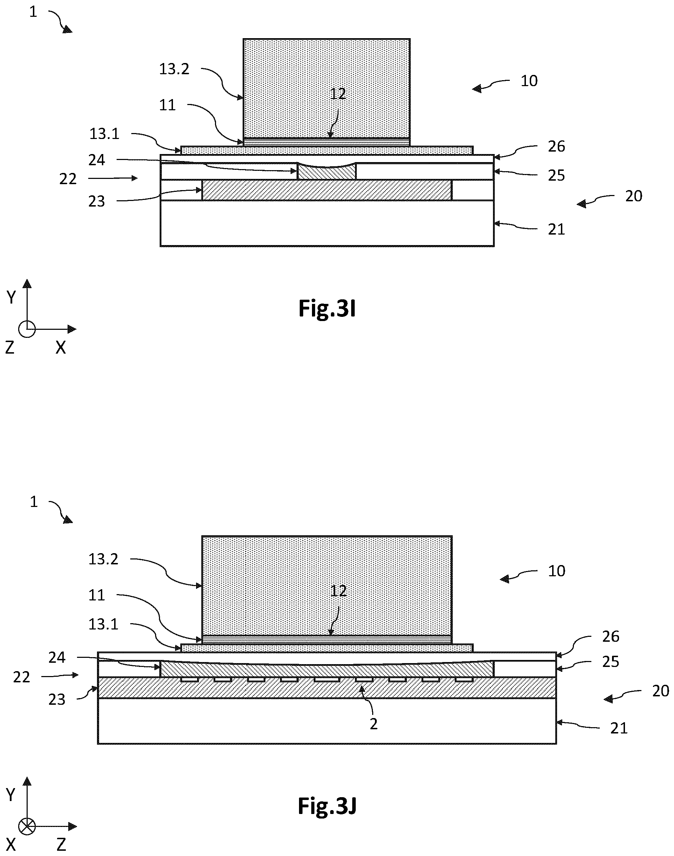

Les figures 31 et 3J illustrent la réalisation du plot semiconducteur 10 sur le substrat fonctionnalisé 20. De manière connue, on réalise un assemblage par collage sur le substrat fonctionnalisé 20 d'un empilement de couches semiconductrices ici de type III-V comportant des puits quantiques. Des étapes de structuration de l'empilement semiconducteur sont ensuite effectuées pour obtenir le plot semiconducteur 10 de dimension souhaitée et comportant un guide d'onde actif 12.

Il en résulte donc que, en disposant le réseau de Bragg 2 dans la première partie 23 du guide d'onde intégré 22 (ici le plateau 23), et plus précisément dans sa face supérieure, on évite que la dépression 32 (*dishing*) pouvant être formée par l'étape de CMP ne dégrade l'homogénéité des dimensions des motifs du réseau de Bragg 2. Par ailleurs, on écarte les risques de perte de contact latéral entre les dents 2.1 en silicium cristallin du réseau de Bragg 2 et la couche intermédiaire 25 en oxyde de silicium. On préserve ainsi les performances du réseau de Bragg 2 et donc celles de la source laser 1.

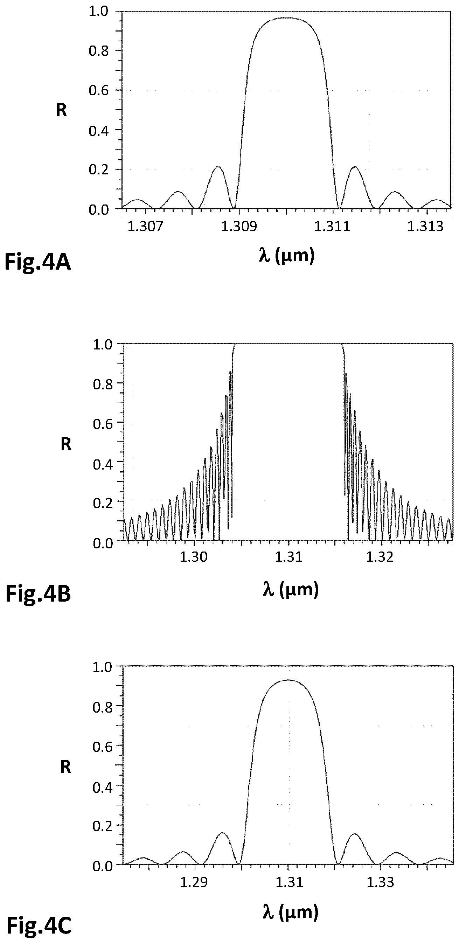

Les figures 4A à 4C illustrent des exemples de réponse spectrale en réflectivité de différents réseaux de Bragg.

La figure 4A correspond à un guide d'onde intégré 22 identique ou similaire à celui décrit en référence aux fig.1A et 1B. Il est formé d'un plateau 23 en silicium monocristallin d'une largeur W1 de 10µm et d'une épaisseur H1 de 300nm. Il est recouvert localement par une arête longitudinale 24 en silicium amorphe d'une largeur W2 de 3µm et d'une épaisseur H2 de 200nm. Il est entouré de SiO₂. Le réseau de Bragg 2 est situé dans la face supérieure de l'arête longitudinale 24, et n'est donc pas un réseau de Bragg 2 intercalaire. Il est formé d'une alternance périodique de creux 2.2 d'une profondeur de 10nm et d'une largeur ici égale à W2 suivant l'axe X, et de dents 2.1 d'une dimension suivant l'axe Z de P=λ/2n_{eff}, soit égale à 200nm environ, P étant la période du réseau de Bragg et n_{eff} l'indice effectif du mode optique (n_{eff}≈3.29 pour le mode hybride III-V/silicium). Suivant l'axe Z, les creux 2.2 et les dents 2.1 présentent de préférence un facteur de remplissage de 50% (P/2). La longueur d'onde du mode guidé est ici de 1.31µm. Il apparaît que, pour un tel réseau de Bragg 2 d'une longueur de 300µm, la réponse spectrale en réflectivité (estimée par un logiciel commercial de simulation de type Rsoft GratingMOD) présente un pic d'une valeur maximale de 97% et une largeur à mi-hauteur de 1.8nm.

La figure 4B correspond à un guide d'onde intégré 22 à réseau de Bragg 2 intercalaire identique ou similaire à celui décrit en référence aux fig.3I et 3J. Le guide d'onde intégré 22 est formé d'un plateau 23 en silicium cristallin d'une largeur W1 de 10µm et d'une épaisseur H1 de 300nm. Le réseau de Bragg 2 est formé dans la face supérieure du plateau 23. Il présente les mêmes dimensions que celui de la fig.4A, et les creux 2.2 sont remplis de SiO₂. L'arête longitudinale 24 en silicium amorphe recouvre le plateau 23 et le réseau de Bragg 2. Elle présente une largeur W2 de 3µm et une épaisseur H2 de 200nm. Il apparaît que, pour un tel réseau de Bragg 2 d'une longueur de 300µm et une longueur d'onde de 1.31µm, la réponse spectrale en réflectivité présente un pic plus élevé, égal à 100%, et une largeur à mi-hauteur plus importante, égale à 12nm.

La figure 4C correspond à un guide d'onde intégré 22 à réseau de Bragg 2 intercalaire similaire à celui décrit en référence à la fig.4B, et en diffère uniquement en ce qu'il présente une longueur de 30µm. La réponse spectrale en réflectivité d'un tel réseau présente ici un pic égal à 93% et une largeur à mi-hauteur de 16nm.

Aussi, le guide d'onde intégré 22 comportant un réseau de Bragg 2 intercalaire situé entre la première partie 23 et la deuxième partie 24 peut présenter des performances plus élevées à longueur de réseau équivalente, ou peut présenter des performances équivalentes à longueur de réseau réduite, selon les applications visées.

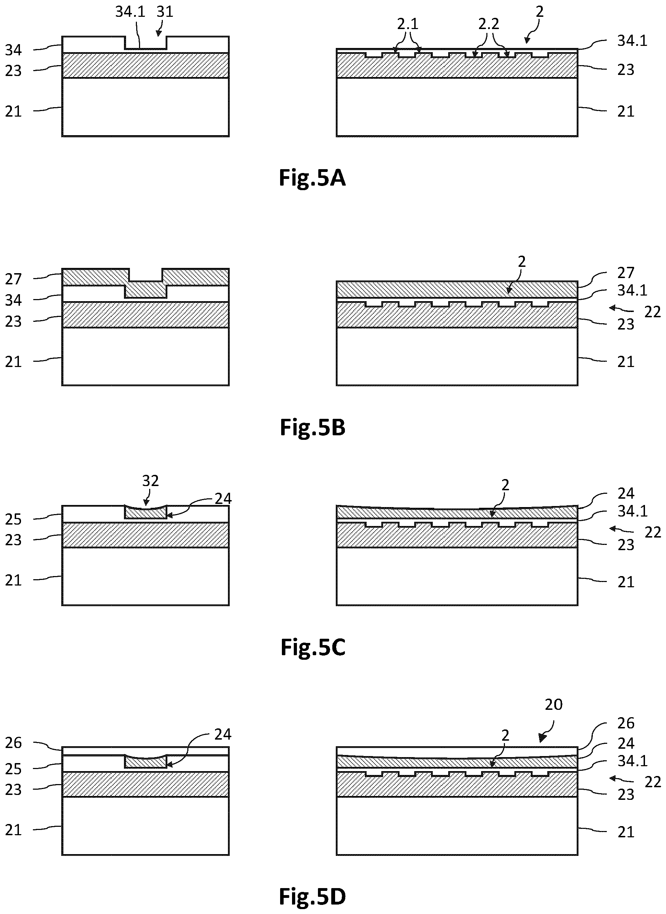

Les figures 5A à 5D illustrent certaines étapes d'un procédé de fabrication d'une source laser 1 selon une variante de réalisation. La source laser 1 selon ce mode de réalisation diffère de celle décrite en référence aux fig.3A et suivantes essentiellement en ce que le guide d'onde intégré 22 comporte une couche mince continue 34.1 en le matériau de bas indice disposée à l'interface entre la première partie 23 et la deuxième partie 24.

Le procédé de fabrication comporte des étapes de réalisation d'un plateau 23 en silicium cristallin à partir d'un substrat SOI, de réalisation du masque de gravure 33 comportant des échancrures 33.1, de gravure du masque de gravure 33 et de réalisation du réseau de Bragg 2 dans le plateau 23, et de dépôt d'une couche de remplissage 34 en un matériau de bas indice. Ces étapes sont identiques ou similaires à celles décrites en référence aux fig.3A à 3D et ne sont pas décrites à nouveau.

La figure 5A illustre la réalisation d'une ouverture longitudinale 31 dans la couche de remplissage 34, destinée à la réalisation de l'arête longitudinale 24 en silicium amorphe du guide d'onde intégré 22. L'ouverture longitudinale 31 est ici réalisée par gravure sèche avec arrêt au temps, de sorte qu'elle n'est pas traversante mais conserve une couche mince continue 34.1 qui recouvre la face supérieure du plateau 23 en silicium cristallin. Aussi, les dents 2.1 en silicium cristallin restent recouvertes par la couche mince continue 34.1, laquelle remplit toujours les creux 2.2 du réseau de Bragg 2. La couche mince continue 34.1 présente une épaisseur choisie de manière à être optiquement neutre vis-à-vis du mode optique guidé. Pour cela, elle présente une épaisseur au niveau des dents 2.1 du réseau de Bragg 2 de préférence inférieure ou égale à 20nm. Par ailleurs, elle présente une face supérieure sensiblement plane.

Les figures 5B, 5C et 5D sont respectivement des étapes de dépôt du silicium amorphe, de planarisation CMP puis de dépôt de la couche supérieure 26 en oxyde de silicium. Ces étapes sont identiques ou similaires à celles décrites précédemment.

On obtient ainsi un guide d'onde intégré 22 formé d'une première partie 23 en silicium cristallin comportant un réseau de Bragg 2 intercalaire situé dans sa face supérieure, d'une couche mince continue 34.1 en un matériau de bas indice qui remplit les creux 2.2 du réseau de Bragg 2 et recouvre la première partie 23, et d'une deuxième partie 24 en silicium amorphe qui repose au contact de la couche mince continue 34.1.

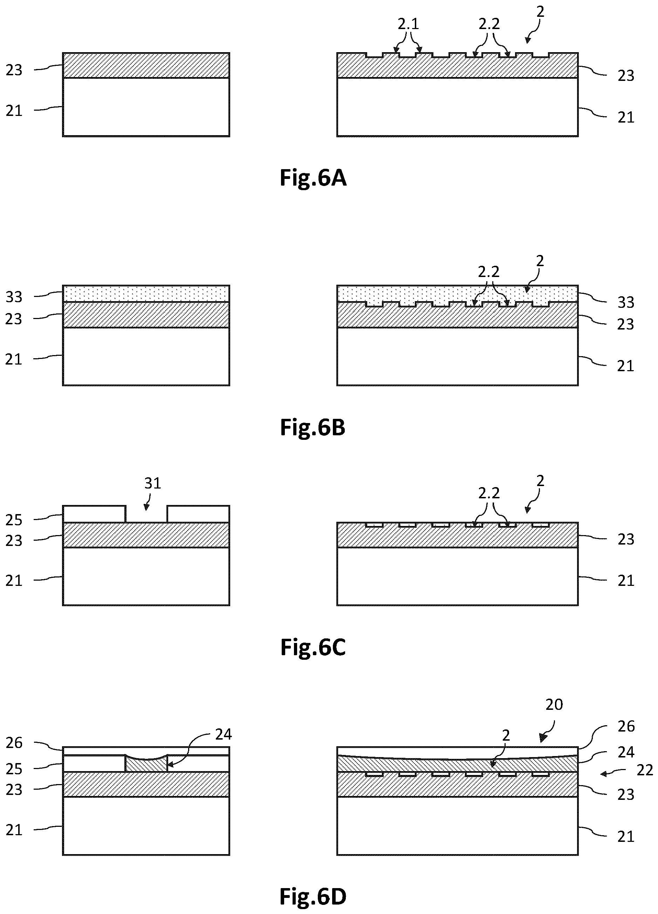

Les figures 6A à 6D illustrent certaines étapes d'un procédé de fabrication d'une source laser 1 selon une autre variante de réalisation. La source laser 1 selon ce mode de réalisation diffère de celle décrite en référence aux fig.3A et suivantes essentiellement en ce que les creux 2.2 du réseau de Bragg 2 sont remplis par un nitrure de silicium et non pas par un oxyde de silicium.

Le procédé de fabrication comporte des étapes de réalisation d'un plateau 23 en silicium cristallin à partir d'un substrat SOI, et de réalisation du masque de gravure 33 comportant des échancrures 33.1. Ces étapes sont identiques ou similaires à celles décrites en référence aux fig.3A et 3B et ne sont pas décrites à nouveau.

La figure 6A illustre la structure obtenue à la suite de l'étape de gravure du masque de gravure 33 et de réalisation du réseau de Bragg 2 dans le plateau 23. Cette étape est similaire à celle décrite en référence à la fig.3C.

La figure 6B illustre le dépôt d'une couche de remplissage 34 en un matériau de bas indice différent de l'oxyde de silicium, par exemple un nitrure de silicium. Le nitrure de silicium recouvre le plateau 23 et donc remplit entièrement les creux 2.2 du réseau de Bragg 2.

La figure 6C illustre la réalisation d'une ouverture longitudinale 31 dans une couche intermédiaire 25 d'oxyde de silicium. Au préalable, la couche de remplissage 34 est amincie par CMP jusqu'à rendre libre la surface supérieure des dents 2.1 en silicium cristallin. Les creux 2.2 du réseau de Bragg 2 restent remplis par le nitrure de silicium. Une couche intermédiaire 25 en oxyde de silicium est ensuite déposée de manière à recouvrir le plateau 23, puis une ouverture longitudinale 31 est réalisée par gravure sèche par exemple de type RIE avec détection de la fin de gravure sur le silicium cristallin du plateau 23. On limite ainsi une éventuelle surgravure du nitrure de silicium situé dans les creux 2.2 du réseau de Bragg 2.

La figure 6D illustre la structure obtenue après les étapes de dépôt du silicium amorphe, de planarisation par CMP et de dépôt de la couche supérieure 26 en oxyde de silicium. Ces étapes sont similaires à celles décrites en référence aux fig. 3F à 3H.

On obtient ainsi un guide d'onde intégré 22 formé d'une première partie 23 en silicium cristallin comportant un réseau de Bragg 2 intercalaire situé dans sa face supérieure, les creux 2.2 du réseau de Bragg 2 étant remplis par un nitrure de silicium, et d'une deuxième partie 24 en silicium amorphe qui repose au contact de la couche mince continue 34.1. On évite ainsi d'avoir une couche mince continue 34.1 située à l'interface entre les première et deuxième parties 23, 24 du guide d'onde intégré 22, et on limite les risques de surgravure du matériau de bas indice situé dans les creux 2.2 du réseau de Bragg 2.

Des modes de réalisation particuliers viennent d'être décrits. Différentes variantes et modifications apparaîtront à l'homme du métier.

Le guide d'onde intégré 22 décrit précédemment est un guide d'onde en arête. En variante, le guide d'onde intégré 22 peut être un guide d'onde droit, c'est-à-dire un guide d'onde formée d'une première partie 23 et d'une deuxième partie 24 présentant une même largeur suivant l'axe longitudinal. De même, la deuxième partie 24 peut présenter une largeur locale supérieure à celle de la première partie 23 (guide en arête inversé).

La source laser décrite précédemment est de type DFB mais elle peut être de type DBR. Aussi, deux réseaux de Bragg sont disposés de part et d'autre du plot semiconducteur 10 et délimitent la cavité optique de la source laser.

## Revendications

1. Source laser (1) comportant :
∘ un substrat dit fonctionnalisé (20), comportant un guide d'onde dit intégré (22)
• formé d'un empilement d'une première partie (23) et d'une deuxième partie (24), une face supérieure de la première partie (23) étant revêtue au moins partiellement par une deuxième partie (24), et
• comportant au moins un réseau de Bragg (2) ;
∘ un plot semiconducteur (10), reposant sur le substrat fonctionnalisé (20), comportant un matériau à gain situé dans un guide d'onde dit actif (12), le guide d'onde actif (12) étant situé à la perpendiculaire du guide d'onde intégré (22) et orienté parallèlement à celui-ci, les deux guides d'onde (12 ; 22) étant couplés optiquement l'un à l'autre ;
∘ **caractérisée en ce que** le réseau de Bragg (2) est situé dans la face supérieure de la première partie (23), et est recouvert par la deuxième partie (24).

2. Source laser (1) selon la revendication 1, dans laquelle le réseau de Bragg (2) est formé par une alternance périodique de dents (2.1) et de creux (2.2), les creux (2.2) étant remplis par un matériau de bas indice de réfraction inférieur à l'indice de réfraction des première et deuxième parties (23, 24).

3. Source laser (1) selon la revendication 1 ou 2, dans laquelle la deuxième partie (24) repose sur une surface sensiblement plane.

4. Source laser (1) selon l'une quelconque des revendications 1 à 3, dans laquelle le guide d'onde intégré (22) est réalisé en silicium et est entouré d'un oxyde de silicium, et dans laquelle le réseau de Bragg (2) comporte des creux (2.2) remplis par un oxyde ou par un nitrure de silicium.

5. Source laser (1) selon l'une quelconque des revendications 1 à 4, dans laquelle la première partie (23) du guide d'onde intégré (22) est réalisée en silicium cristallin, et la deuxième partie (24) est réalisée en silicium amorphe.

6. Source laser (1) selon l'une quelconque des revendications 1 à 5, dans laquelle le réseau de Bragg (2) comporte une alternance périodique de dents (2.1) et de creux (2.2), la deuxième partie (24) étant au contact des dents (2.1) du réseau de Bragg (2).

7. Source laser (1) selon l'une quelconque des revendications 1 à 5, dans laquelle le réseau de Bragg (2) comporte une alternance périodique de dents (2.1) et de creux (2.2), le guide d'onde intégré (22) comportant une couche mince continue (34.1) en un matériau de bas indice de réfraction qui recouvre la première partie (23) et remplit les creux (2.2) du réseau de Bragg (2), la deuxième partie (24) étant espacée de la première partie (23) par la couche mince continue (34.1).

8. Source laser (1) selon l'une quelconque des revendications 1 à 7, dans laquelle la deuxième partie (24) forme une arête longitudinale d'une largeur inférieure à celle de la première partie (23).

9. Procédé de fabrication d'une source laser (1) selon l'une quelconque des revendications précédentes, comportant les étapes suivantes :
∘ réalisation d'une première partie (23) du guide d'onde intégré (22) reposant sur une couche de base (21) ;
∘ réalisation d'au moins un réseau de Bragg (2) dans la face supérieure de la première partie (23) opposée à la couche de base (21), le réseau de Bragg (2) étant formé d'une alternance de dents (2.1) et de creux (2.2) ;
∘ remplissage des creux (2.2) par un matériau de bas indice de réfraction ;
∘ réalisation d'une deuxième partie (24) du guide d'onde intégré (22) sur la première partie (23) et recouvrant le réseau de Bragg (2) ;
∘ réalisation d'une couche supérieure (26) recouvrant la deuxième partie (24) ;
∘ réalisation du plot semiconducteur (10) reposant sur la couche supérieure (26).

10. Procédé de fabrication selon la revendication 9, dans lequel l'étape de réalisation de la première partie (23) est effectuée par gravure localisée d'une couche de silicium cristallin d'un substrat SOI, la première partie (23) présentant une épaisseur égale à l'épaisseur de la couche de silicium cristallin, et homogène spatialement.

11. Procédé de fabrication selon la revendication 9 ou 10, dans lequel l'étape de réalisation de la deuxième partie (24) du guide d'onde intégré (22) est effectuée par un procédé damascène comportant les étapes suivantes :
∘ réalisation d'une couche formant un masque et recouvrant la première partie (23) et le réseau de Bragg (2) ;
∘ réalisation d'une ouverture longitudinale (31) à la perpendiculaire du réseau de Bragg (2) ;
∘ dépôt de silicium amorphe remplissant l'ouverture longitudinale (31) ;
∘ planarisation mécano-chimique de manière à rendre libre une face supérieure du masque et à conserver le silicium amorphe remplissant l'ouverture longitudinale (31).

12. Procédé de fabrication selon la revendication 11, le réseau de Bragg (2) étant formé d'une alternance périodique de dents (2.1) et de creux (2.2), dans lequel, à la suite de l'étape de réalisation de l'ouverture longitudinale (31), une surface de la face supérieure de la première partie (23) est rendue libre, ladite surface libre étant formée par des dents (2.1) en silicium et par le matériau de bas indice de réfraction remplissant les creux (2.2) du réseau de Bragg (2).

13. Procédé de fabrication selon la revendication 11, le réseau de Bragg (2) étant formé d'une alternance périodique de dents (2.1) et de creux (2.2), dans lequel à la suite de l'étape de réalisation de l'ouverture longitudinale (31), une couche mince continue (34.1) de la couche en oxyde de silicium recouvre les dents (2.1) en silicium et remplit les creux (2.2) du réseau de Bragg (2).

## Patentansprüche

1. Laserquelle (1), die Folgendes umfasst:
o ein sogenanntes funktionalisiertes Substrat (20), das einen sogenannten integrierten Wellenleiter (22) umfasst,
• der aus einem Stapel aus einem ersten Abschnitt (23) und einem zweiten Abschnitt (24) gebildet ist, wobei eine obere Fläche des ersten Abschnitts (23) mindestens teilweise von einem zweiten Abschnitt (24) bedeckt wird, und
• der mindestens ein Bragg-Gitter (2) umfasst;
∘ einen Halbleiterblock (10), der auf dem funktionalisierten Substrat (20) liegt und ein Verstärkungsmaterial umfasst, das sich in einem sogenannten aktiven Wellenleiter (12) befindet, wobei der aktive Wellenleiter (12) senkrecht zu dem integrierten Wellenleiter (22) und parallel zu diesem ausgerichtet ist, wobei die zwei Wellenleiter (12; 22) optisch miteinander gekoppelt sind;
∘ **dadurch gekennzeichnet, dass** sich das Bragg-Gitter (2) in der oberen Fläche des ersten Abschnitts (23) befindet und von dem zweiten Abschnitt (24) abgedeckt wird.

2. Laserquelle (1) nach Anspruch 1, wobei das Bragg-Gitter (2) aus einem periodischen Wechsel von Zähnen (2.1) und Aussparungen (2.2) gebildet ist, wobei die Aussparungen (2.2) mit einem Material mit niedrigem Brechungsindex, der kleiner als der Brechungsindex des ersten und zweiten Abschnitts (23, 24) ist, gefüllt sind.

3. Laserquelle (1) nach Anspruch 1 oder 2, wobei der zweite Abschnitt (24) auf einer im Wesentlichen ebenen Oberfläche liegt.

4. Laserquelle (1) nach einem der Ansprüche 1 bis 3, wobei der integrierte Wellenleiter (22) aus Silicium besteht und von einem Siliciumoxid umgeben ist und wobei das Bragg-Gitter (2) Aussparungen (2.2) umfasst, die mit einem Siliciumoxid oder -nitrid gefüllt sind.

5. Laserquelle (1) nach einem der Ansprüche 1 bis 4, wobei der erste Abschnitt (23) des integrierten Wellenleiters (22) aus kristallinem Silicium besteht und der zweite Abschnitt (24) aus amorphem Silicium besteht.

6. Laserquelle (1) nach einem der Ansprüche 1 bis 5, wobei das Bragg-Gitter (2) einen periodischen Wechsel von Zähnen (2.1) und Aussparungen (2.2) umfasst, wobei der zweite Abschnitt (24) mit den Zähnen (2.1) des Bragg-Gitters (2) in Kontakt ist.

7. Laserquelle (1) nach einem der Ansprüche 1 bis 5, wobei das Bragg-Gitter (2) einen periodischen Wechsel von Zähnen (2.1) und Aussparungen (2.2) umfasst, wobei der integrierte Wellenleiter (22) eine durchgehende Dünnschicht (34.1) aus einem Material mit niedrigem Brechungsindex umfasst, die den ersten Abschnitt (23) abdeckt und die Aussparungen (2.2) des Bragg-Gitters (2) füllt, wobei der zweite Abschnitt (24) durch die durchgehende Dünnschicht (34.1) von dem ersten Abschnitt (23) beabstandet ist.

8. Laserquelle (1) nach einem der Ansprüche 1 bis 7, wobei der zweite Abschnitt (24) eine Längsrippe mit einer Breite, die kleiner als die des ersten Abschnitts (23) ist, bildet.

9. Verfahren zur Fertigung einer Laserquelle (1) nach einem der vorhergehenden Ansprüche, das die folgenden Schritte umfasst:
o Erstellen eines ersten Abschnitts (23) des integrierten Wellenleiters (22), der auf einer Basisschicht (21) liegt;
o Erstellen mindestens eines Bragg-Gitters (2) in der oberen Fläche des ersten Abschnitts (23), die von der Basisschicht (21) abgewandt ist, wobei das Bragg-Gitter (2) aus einem Wechsel von Zähnen (2.1) und Aussparungen (2.2) gebildet ist;
∘ Füllen der Aussparungen (2.2) mit einem Material mit niedrigem Brechungsindex;
∘ Erstellen eines zweiten Abschnitts (24) des integrierten Wellenleiters (22) auf dem ersten Abschnitt (23), der das Bragg-Gitter (2) abdeckt;
∘ Erstellen einer oberen Schicht (26), die den zweiten Abschnitt (24) abdeckt;
∘ Erstellen des Halbleiterblocks (10), der auf der oberen Schicht (26) liegt.

10. Fertigungsverfahren nach Anspruch 9, wobei der Schritt des Erstellens des ersten Abschnitts (23) durch lokales Ätzen einer Schicht aus kristallinem Silicium eines SOI-Substrats erfolgt, wobei der erste Abschnitt (23) eine Dicke aufweist, die gleich der Dicke der Schicht aus kristallinem Silicium ist und räumlich homogen ist.

11. Fertigungsverfahren nach Anspruch 9 oder 10, wobei der Schritt des Erstellens des zweiten Abschnitts (24) des integrierten Wellenleiters (22) durch ein Damaszenverfahren erfolgt, das die folgenden Schritte umfasst:
∘ Erstellen einer Schicht, die eine Maske bildet und den ersten Abschnitt (23) und das Bragg-Gitter (2) abdeckt;
∘ Erstellen einer Längsöffnung (31) senkrecht zu dem Bragg-Gitter (2);
∘ Abscheiden von amorphem Silicium, das die Längsöffnung (31) füllt;
∘ chemisch-mechanisches Planarisieren, um eine obere Fläche der Maske freizulegen und das amorphe Silicium, das die Längsöffnung (31) füllt, zu bewahren.

12. Fertigungsverfahren nach Anspruch 11, wobei das Bragg-Gitter (2) aus einem periodischen Wechsel von Zähnen (2.1) und Aussparungen (2.2) gebildet ist, wobei im Anschluss an den Schritt des Erstellens der Längsöffnung (31) eine Oberfläche der oberen Fläche des ersten Abschnitts (23) freigelegt wird, wobei die freie Oberfläche durch Zähne (2.1) aus Silicium und das Material mit niedrigem Brechungsindex, das die Aussparungen (2.2) des Bragg-Gitters (2) füllt, gebildet ist.

13. Fertigungsverfahren nach Anspruch 11, wobei das Bragg-Gitter (2) aus einem periodischen Wechsel von Zähnen (2.1) und Aussparungen (2.2) gebildet ist, wobei im Anschluss an den Schritt des Erstellens der Längsöffnung (31) eine durchgehende Dünnschicht (34.1) der Schicht aus Siliciumoxid die Zähne (2.1) aus Silicium abdeckt und die Aussparungen (2.2) des Bragg-Gitters (2) füllt.

## Claims

1. Laser source, comprising:
∘ a substrate (20), referred to as the functionalized substrate, comprising a waveguide (22), referred to as the integrated waveguide,
• said waveguide being formed from a stack of a first portion (23) and of a second portion (24), an upper face of the first portion (23) being at least partially coated with a second portion (24), and
• comprising at least one Bragg grating (2); and
∘ a semiconductor pad (10), resting on the functionalized substrate (20), comprising a gain medium located in a waveguide (12) that is referred to as the active waveguide, the active waveguide (12) being located perpendicular to the integrated waveguide (22) and oriented parallel thereto, the two waveguides (12; 22) being optically coupled to each other,
∘ **characterized in that** the Bragg grating (2) is located in the upper face of the first portion (23), and is covered by the second portion (24).

2. Laser source (1) according to Claim 1, wherein the Bragg grating (2) is formed by a periodic alternation of peaks (2.1) and of troughs (2.2), the troughs (2.2) being filled with a material of low refractive index, the refractive index of which is lower than the refractive index of the first and second portions (23, 24).

3. Laser source (1) according to Claim 1 or 2, wherein the second portion (24) rests on a substantially planar surface.

4. Laser source (1) according to any one of Claims 1 to 3, wherein the integrated waveguide (22) is made of silicon and is encircled by a silicon oxide, and wherein the Bragg grating (2) comprises troughs (2.2) filled with a silicon oxide or with a silicon nitride.

5. Laser source (1) according to any one of Claims 1 to 4, wherein the first portion (23) of the integrated waveguide (22) is made of crystalline silicon, and the second portion (24) is made of amorphous silicon.

6. Laser source (1) according to any one of Claims 1 to 5, wherein the Bragg grating (2) comprises a periodic alternation of peaks (2.1) and of troughs (2.2), the second portion (24) making contact with the peaks (2.1) of the Bragg grating (2).

7. Laser source (1) according to any one of Claims 1 to 5, wherein the Bragg grating (2) comprises a periodic alternation of peaks (2.1) and of troughs (2.2), the integrated waveguide (22) comprising a thin continuous layer (34.1) made of a material of low refractive index that covers the first portion (23) and fills the troughs (2.2) of the Bragg grating (2), the second portion (24) being spaced apart from the first portion (23) by the thin continuous layer (34.1).

8. Laser source (1) according to any one of Claims 1 to 7, wherein the second portion (24) forms a longitudinal rib of a width smaller than that of the first portion (23).

9. Process for fabricating a laser source (1) according to any one of the preceding claims, comprising the following steps:
o producing a first portion (23) of the integrated waveguide (22) resting on a base layer (21);
o producing at least one Bragg grating (2) in the upper face of the first portion (23) opposite the base layer (21), the Bragg grating (2) being formed from an alternation of peaks (2.1) and troughs (2.2);
o filling the troughs (2.2) with a material of low refractive index;
o producing a second portion (24) of the integrated waveguide (22) on the first portion (23) and covering the Bragg grating (2);
o producing an upper layer (26) covering the second portion (24);
o producing the semiconductor pad (10) resting on the upper layer (26).

10. Fabricating process according to Claim 9, wherein the step of producing the first portion (23) is performed by locally etching a layer of crystalline silicon of an SOI substrate, the first portion (23) having a spatially uniform thickness equal to the thickness of the layer of crystalline silicon.

11. Fabricating process according to Claim 9 or 10, wherein the step of producing the second portion (24) of the integrated waveguide (22) is performed using a damascene process comprising the following steps:
o producing a layer forming a mask and covering the first portion (23) and the Bragg grating (2);
o producing a longitudinal aperture (31) perpendicular to the Bragg grating (2);
o depositing amorphous silicon filling the longitudinal aperture (31);
o carrying out chemical-mechanical planarization so as to free an upper face of the mask and to preserve the amorphous silicon filling the longitudinal aperture (31).

12. Fabricating process according to Claim 11, the Bragg grating (2) being formed from a periodic alternation of peaks (2.1) and of troughs (2.2), wherein, following the step of producing the longitudinal aperture (31), a surface of the upper face of the first portion (23) is rendered free, said free surface being formed by peaks (2.1) made of silicon and by the material of low refractive index filling the troughs (2.2) of the Bragg grating (2).

13. Fabricating process according to Claim 11, the Bragg grating (2) being formed from a periodic alternation of peaks (2.1) and of troughs (2.2), wherein, following the step of producing the longitudinal aperture (31), a thin continuous layer (34.1) of the layer made of silicon oxide covers the peaks (2.1) made of silicon and fills the troughs (2.2) of the Bragg grating (2).
